# EUROPEAN PATENT APPLICATION

(11) **EP 1 104 113 A2**
(43) Date of publication of application: **30.05.2001**
(21) Application number: 00310450.2
(22) Date of filing: 24.11.2000
(51) Int. Cl.: H03L 7/18, H03L 7/087

(54) **Clock and data recovery circuit for optical receiver**

(30) Priority: 24.11.1999 JP 33216899
(71) Applicant: NEC CORPORATION, Tokyo (JP)
(72) Inventor: Yoshida, Toshiro, Tokyo (JP); Tajima, Tsutomu, Tokyo (JP)
(74) Representative: Moir, Michael Christopher

(57) **Abstract**

A CDR (Clock and Data Recovery) circuit for an optical receiver has a PLL (Phase-Locked Loop) circuit for reproducing a clock signal from an input data signal. In this circuit, a frequency-dividing ratio in the PLL circuit is switched in accordance with an instruction signal from the outside.

## Description

### FIELD OF THE INVENTION

The present invention relates to a CDR (Clock and Data Recovery) circuit for an optical receiver and, more particularly, to a CDR circuit for use in an optical receiver of an optical communication apparatus.

### BACKGROUND OF THE INVENTION

Commercialization of an optical fiber amplifier realizes higher speed, larger capacity, and longer distance of optical communications. In recent years, a wavelength multiplexing optical communication apparatus of a very large capacity making the most of the features of the optical fiber amplifier has been developed. A wavelength-multiplexing transmissions multiplexing and transmitting a 2.4 Gbps signal of 32 wavelengths in a 1550 nm band, has already been put into practical use. Aiming at larger capacity. commercialization of a system of 80 wavelengths or 160 wavelengths at 2.4 Gbps and a system of 32 wavelengths or 64 wavelengths at 10 Gbps is being studied.

An increase in transmission capacity realized by an increase in wavelength and transmission speed, however, inevitably deteriorates a S/N ratio (signal-to-noise ratio). It limits the transmission distance and deteriorates transmission quality (frequency of occurrence of a signal error in a digital transmission system).

In order to prevent this, application of FEC (Forward Error Correction) is being considered. For example, as an optical submarine cable system, a system to which the FEC is applied has already been practically used. The FEC is a method of transmitting information of an original signal as redundant bits, and, when a coding error occurs, reconstructing the signal by correcting the error on the reception side. Since the original signal information is added as redundant bits, the transmission speed increases.

One method generally used at present is a method of converting signals of 238 bytes with a redundant signal into signals of 255 bytes. In the case of the method, the transmission speed increases by about 7% (255/238 = 15/14).

An optical transmitter and receiver used for the systems inherently have a corresponding single transmission speed. The optical transmitter can be generally used at an original signal transmission speed and even when the transmission speed is increased by the FEC as long as it is within an operation speed margin.

As for the optical receiver, however, since a filter and a PLL (Phase Locked Loop) each adapted to the transmission speed are used, it is difficult to commonly use the optical receiver at two transmission speeds.

### SUMMARY OF THE INVENTION

It is therefore an object of the preferred embodiments of the invention to provide a CDR circuit for an optical receiver, which solves the above-described problem and can reproduce both a clock signal at a basic bit rate and a clock signal to which the FEC is applied.

According to the invention, there is provided a CDR (Clock and Data Recovery) circuit for an optical receiver, comprising a PLL (Phase-Locked Loop) circuit for reproducing a clock signal from an input data signal, wherein a frequency dividing ratio in the PLL circuit is switched in accordance with an instruction signal from the outside.

According to the invention, there is also provided a CDR (Clock and Data Recovery) circuit for an optical receiver, comprising: a PLL (Phase Locked Loop) circuit for reproducing a clock signal from an input data signal; a reference signal generator for generating a reference signal to the PLL circuit; and a discriminator for discriminating and reproducing the input data signal by a clock signal outputted from the PLL circuit, the PLL circuit having: a voltage controlled oscillator of which oscillation frequency is changed by a control voltage; a frequency divider which divides the frequency of an output signal of the voltage controlled oscillator and of which a frequency-dividing ratio can be varied; a first frequency/phase comparator for comparing a frequency and a phase of an input data signal with those of an output signal of the voltage-controlled oscillator; a second frequency/phase comparator for comparing a frequency and a phase of the output signal of the frequency divider and those of a reference signal of the reference signal generator; an unlocked state detector for detecting an unlocked state of the PLL loop from an output signal of the second frequency/phase comparator; and a switch for switching between the output signal of the first frequency/phase comparator and the output signal of the second frequency/phase comparator in accordance with a detection result of the unlocked state detector, wherein the frequency dividing ratio of the frequency divider is switched in accordance with an instruction signal from the outside.

That is, the CDR circuit for an optical receiver of the invention is a CDR circuit for use in an optical receiver of an optical communication apparatus. By switching the frequency dividing ratio of the frequency divider in the PLL by an external control signal, the CDR circuit can also deal with the data signal to which the FEC is applied. Thus. the above problem can be solved and the CDR circuit for an optical receiver adapted to the FEC which is becoming more important, can be provided.

### BRIEF DESCRIPTION OF THE DRAWINGS

Preferred features of the present invention will now be described, by way of example only, with reference to the accompanying drawings, in which:-

Fig. 1 is a block diagram showing the configuration of a CDR circuit for an optical receiver according to an embodiment of the invention.

Fig. 2 is a block diagram showing the configuration of a CDR circuit for an optical receiver according to another embodiment of the invention.

### DETAILED DESCRIPTION OF THE PREFERRED EMBODIMENTS

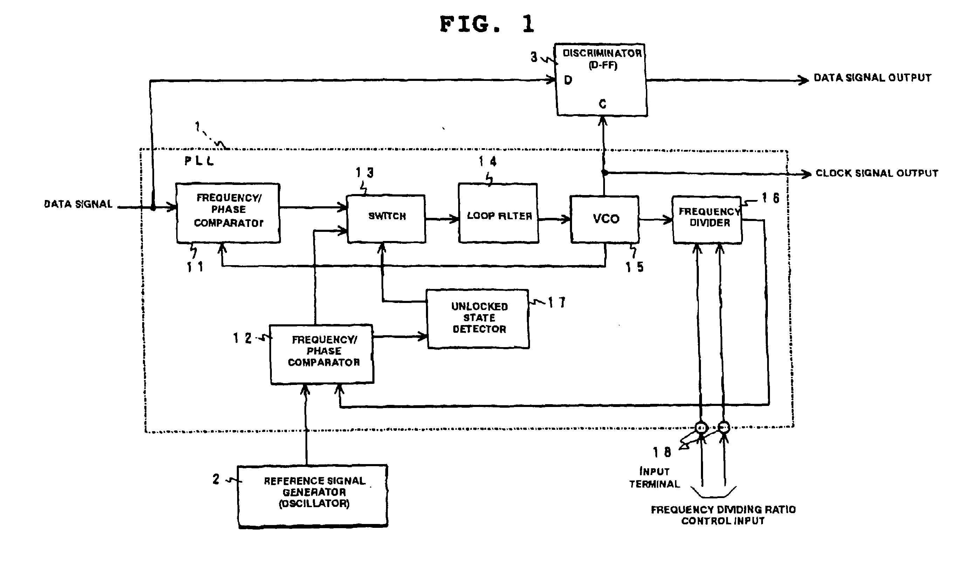

Embodiments of the invention will be described hereinbelow with reference to the drawings, Fig. 1 is a block diagram showing the configuration of a CDR (Clock and Data Recovery) circuit for an optical receiver according to an embodiment of the invention. In Fig. 1, the CDR circuit for an optical receiver according to the embodiment of the invention has: a PLL (Phase Locked Loop) 1, a reference signal generator (oscillator) 2, and a discriminator (D.FF:Dflipflop) 3. The PLL 1 includes frequency/phase comparators 11 and 12, a switch 13, a loop filter 14, a VCO (Voltage Controlled Oscillator) 15, a frequency divider 16, and an unlocked state detector 17.

The frequency/phase comparator 11 compares the frequency and phase of an input data signal and chose of an output signal of the VCO 15. The frequency/phase comparator 12 compares the frequency and phase of an output signal of the frequency divider 16 and those of an output signal of the reference signal generator 2.

The oscillation frequency of the VCO 15 changes in accordance with a control voltage. The frequency divider 16 divides the frequency of an output signal of the VCO 15 and the frequency dividing ratio is varied by a frequency dividing ratio control signal supplied from the outside to an input terminal 18.

The unlocked state detector 17 detects an unlocked state of the PLL loop from an output signal of the frequency/phase comparator 12. The switch 13 switches the signal inputted to the loop filter 14 on the basis of a control signal outputted from the unlocked state detector 17.

The reference signal generator 2 generates a reference signal. The discriminator 3 discriminates and reproduces an input data signal by a clock signal outputted from the VCO 15 and outputs the discriminated and reproduced data signal.

The operation of the CDR circuit for an optical receiver according to the embodiment of the invention will be described by using Fig. 1. First, in a state where the frequency and phase of the VCO 15 are not synchronized with those of an input signal (out of sync of the PLL 1), the unlocked state detector 17 detects the unlocked state of the PLL loop and the switch 13 is switched so as to transfer a signal from the frequency/phase comparator 12 to the loop filter 14.

The frequency/phase comparator 12 compares the frequency and the phase of a signal outputted from the reference signal generator 2 which oscillates at a fixed frequency and those of a signal obtained by dividing the frequency of a signal outputted from the VCO 15 and controls the PLL 1 to enter a locked state.

Once synchronization is established, the switch 13 is switched so as to transfer a signal outputted from the frequency/phase comparator 11 to the loop filter 14. That is, the frequency of the signal outputted from the reference signal generator 2 plays the role of a reference signal which is used to make the PLL 1 enter a sync state. By the above operations, the PLL 1 enters the sync state.

For easier understanding, transmission at 2.48832 Gpbs will be described as an example. In the transmission at 2.48832 Gbps, a bit rate in the case where FEC (Forward Error Correction) is applied becomes 2.66606 Gbps which is 15/14 times as high as 2.48832 Gbps. 177.737 MHz as 1/14 of the bit rate is selected as the frequency of the reference signal from the reference signal generator 2. The frequency dividing ratio of the frequency divider 16 is constructed so as to be varied between 1/14 and 1/15 by a frequency dividing ratio control signal. In the case of receiving a signal of 2.48832 Gbps as an input data signal, the frequency dividing ratio of the frequency divider 16 is set to 1/14.

The frequency/phase comparator 12 compares the frequency and phase at 177.737 MHz as the frequency of the reference signal and those at a frequency (177.737 MHz) of the signal obtained by dividing the frequency of an output signal of the VCO 15 to 1/14, and controls the VCO 15 by the result of the comparison so that both of the frequencies coincide with each other. At this time, a data signal (2.48832 GHz) synchronized with a clock signal (output signal of the VCO 15) is outputted from the discriminator 3.

Similarly, in the case of receiving a signal of 2.66606 Gbps as an input data signal, the frequency dividing ratio of the frequency divider 16 is switched to 1/15 by a frequency dividing ratio control signal. In this case, since a synchronizing operation of the PLL 1 is performed between a frequency (177.737 MHz) obtained by dividing 2.66606 GHz to 1/15 and the frequency (177.737 MHz) of the reference signal, the PLL 1 is locked at 2.66606 GHz. At this time, a clock signal (2.66606 GHz) synchronized with an input data signal is outputted as a clock output.

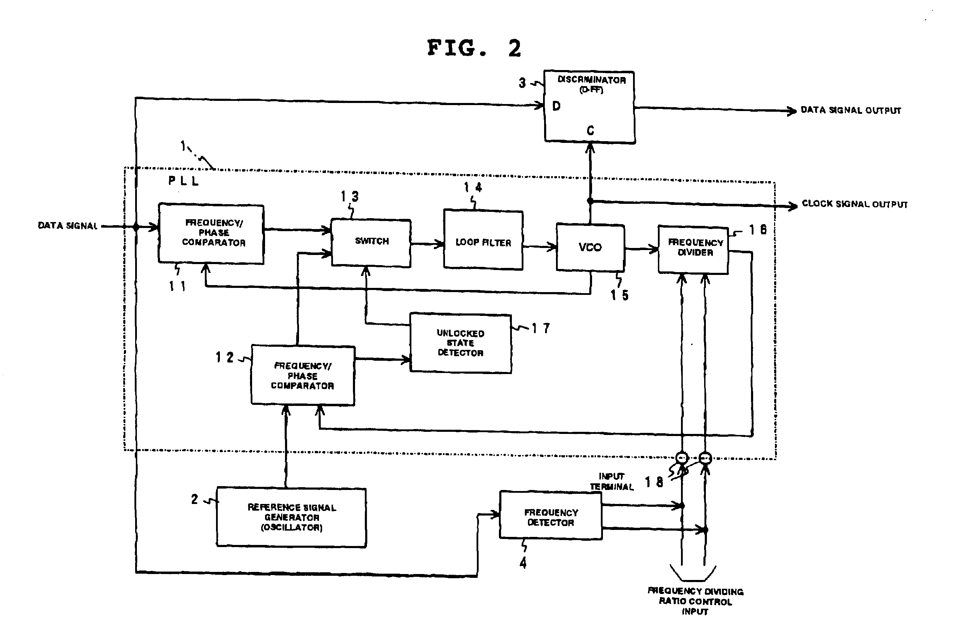

Fig. 2 is a block diagram showing the configuration of a CDR circuit for an optical receiver according to another embodiment of the invention. In Fig. 2, the CDR circuit for an optical receiver according to another embodiment of the invention has a configuration similar to that of the CDR circuit for an optical receiver according to the foregoing embodiment of the invention illustrated in Fig. 1 except that a frequency detector 4 for detecting the frequency of an input data signal is provided. Components having the same configuration are designated by the same reference numerals. The operation of the component having the same configuration is similar to that in the foregoing embodiment.

The frequency detector 4 detects the frequency of an input data signal and transmits a frequency dividing ratio control signal in accordance with the detection result to the frequency divider 16. The frequency divider 16 varies its frequency dividing ratio by the frequency dividing ratio control signal from the frequency detector 4.

For example, when the frequency detector 4 detects a signal of 2.48832 Gbps, the frequency divider 16 switches its frequency dividing ratio to 1/14 by the frequency dividing ratio control signal. When the frequency detector 4 detects a signal of 2.66606 Gbps, the frequency divider 16 switches its frequency dividing ratio to 1/15 by the frequency dividing ratio control signal. Since the operations other than the above operations are similar to those of the foregoing embodiment of the invention, its description is omitted here.

As described above, only by changing the frequency dividing ratio of the frequency divider 16 without changing the frequency of the reference signal generator 2, both of the data signal of 2.48832 Gbps and the data signal of 2.66606 Gbps can be received.

Although only the bit rate of 2.48832 Gbps has been described above, similar effects can be obtained also at other bit rates (for example, 622 Mbps).

By switching the frequency dividing ratio of the frequency divider 16 by a frequency dividing ratio control signal from the outside, both the clock signal of the basic bit rate and the clock signal to which the FEC is applied can be reproduced by the single CDR.

According to the invention as described above, by switching the frequency dividing ratio in the PLL circuit in accordance with the instruction signal from the outside in the CDR circuit for an optical receiver. including the PLL circuit for reproducing a clock signal from an input data signal, an effect is obtained in which both the clock signal of the basic bit rate and the signal to which the FEC is applied can be reproduced.

Although the invention has been described with respect to specific embodiments for complete and clear disclosure, the appended claims are not to be thus limited but are to be construed as embodying all modifications and alternative constructions that may occur to one skilled in the art which fairly fall within the basic teaching herein set forth.

Each feature disclosed in this specification (which term includes the claims) and/or shown in the drawings may be incorporated in the invention independently of other disclosed and/or illustrated features.

The text of the abstract filed herewith is repeated here as part of the specification.

A CDR (Clock and Data Recovery) circuit for an optical receiver has a PLL (Phase-Locked Loop) circuit for reproducing a clock signal from an input data signal. In this circuit, a frequency-dividing ratio in the PLL circuit is switched in accordance with an instruction signal from the outside.

## Claims

1. A CDR (Clock and Data Recovery) circuit for an optical receiver, comprising a PLL (Phase Locked Loop) circuit for reproducing a clock signal from an input data signal,
wherein a frequency-dividing ratio in the PLL circuit is switched in accordance with an external instruction signal.

2. The CDR circuit for an optical receiver according to claim 1, wherein the frequency-dividing ratio is switched in accordance with a frequency of the data signal.

3. The CDR circuit for an optical receiver according to claim 2, further comprising a frequency detector for detecting a frequency of the data signal,
wherein the frequency-dividing ratio is switched in accordance with a detection result of the frequency detector.

4. The CDR circuit for an optical receiver according to claim 1, wherein the frequency-dividing ratio can be varied between 1/14 and 1/15 in accordance with an external instruction signal.

5. A CDR (Clock and Data Recovery) circuit for an optical receiver. comprising:
a PLL (Phase-Locked Loop) circuit for reproducing a clock signal from an input data signal;
a reference signal generator for generating a reference signal to the PLL circuit; and,
a discriminator for discriminating and reproducing the input data signal by a clock signal outputted from the PLL circuit,
the PLL circuit having:
a voltage controlled oscillator of which oscillation frequency is changed by a control voltage;
a frequency divider which divides the frequency of an output signal of the voltage controlled oscillator and of which a frequency-dividing ratio can be varied;
a first frequency/phase comparator for comparing a frequency and a phase of an input data signal with those of an output signal of the voltage controlled oscillator;
a second frequency/phase comparator for comparing a frequency and a phase of the output signal of the frequency divider and those of a reference signal of the reference signal generator;
an unlocked state detector for detecting an unlocked state of the PLL loop from an output signal of the second frequency/phase comparator; and,
a switch for switching between the output signal of the first frequency/phase comparator and the output signal of the second frequency/phase comparator in accordance with a detection result of the unlocked state detector,
wherein the frequency dividing ratio of the frequency divider is switched in accordance with an external instruction signal.

6. The CDR circuit for an optical receiver according to claim 5, wherein the frequency-dividing ratio of the frequency divider is switched in accordance with the frequency of the data signal.

7. The CDR circuit for an optical receiver according to claim 6, further comprising a frequency detector for detecting the frequency of the data signal, wherein the frequency-dividing ratio of the frequency divider is switched in accordance with a detection result of the frequency detector.

8. The CDR circuit for an optical receiver according to claim 5, wherein the frequency-dividing ratio of the frequency divider is preset so that the frequency of the data signal which has been subjected to frequency division is equal to a frequency of the reference signal generated by the reference signal generator.

9. The CDR circuit for an optical receiver according to claim 5, wherein the frequency-dividing ratio of the frequency divider is variable between 1/14 and 1/15 in accordance with the external instruction signal.
